# EUROPEAN PATENT APPLICATION

(11) **EP 2 399 863 A1**
(43) Date of publication of application: **28.12.2011**
(21) Application number: 10166782.2
(22) Date of filing: 22.06.2010
(51) Int. Cl.: B81C 1/00

(54) **Multi-layer substrate structure and manufacturing method for the same**

(71) Applicant: VALTION TEKNILLINEN TUTKIMUSKESKUS, 02044 VTT (FI)
(72) Inventor: Puurunen, Riikka, 02044, VTT (FI); Henttinen, Kimmo, 00920, Helsinki (FI); Kattelus, Hannu, 02044, VTT (FI); Suni, Tommi, 02044, VTT (FI)
(74) Representative: Värilä, Risto Sakari

(57) **Abstract**

A method for manufacturing a multi-layer substrate structure comprising obtaining a first and second wafer, such as two silicon wafers, wherein at least one of the wafers may be optionally provided with a material layer such as an oxide layer (302, 404), forming a cavity on the bond side of the first wafer (306, 406), depositing, preferably by ALD (Atomic Layer Deposition), a material layer, such as alumina layer, on either wafer arranged so as to at least in places face the other wafer and cover at least portion of the cavity of the first wafer, such as bottom, wall and/or edge thereof, and enable stopping etching, such as plasma etching, into the underlying material (308, 408), and bonding the wafers provided with at least the aforesaid ALD layer as an intermediate layer together to form the multi-layer semiconductor substrate structure (310, 312). A related multi-layer substrate structure is presented.

## Description

### FIELD OF THE INVENTION

Generally the present invention pertains to semiconductor manufacturing technology. In particular, however not exclusively, the invention concerns multi-layer wafer substrates incorporating a number of cavity structures.

### BACKGROUND

Silicon on insulator (SOI) wafers are nowadays commonly used in semiconductor industry. Fabrication of SOI wafers may comprise bonding two silicon wafers together, wherein one or both wafers to be combined may be first oxidized. After bonding, one of the bonded wafers may be thinned down to a desired thickness. However, the fabrication of e.g. MEMS (Micro-Electro-Mechanical Systems) structures using such a wafer may be challenging. In many cases the oxide under the SOI layer is used as sacrificial layer to form cavities under the active layer. This creates limitations for the MEMS design as the depth of the cavity is then basically limited to the thickness of the buried oxide, typically being only a few microns. Also the etching speed of the buried oxide may vary causing variations in the achieved pattern shapes and sizes.

Instead, by using SOI wafers with pre-etched cavities (CSOI, cavity-SOI), the shape and size of the cavities may be defined by the limits of the used lithographic patterning method, for example. This enables fabrication of more complicated patterns as well as deeper cavities than with mere buried oxide etching. The utilization of CSOI wafers in MEMS fabrication gives generally more freedom to the MEMS designer.

Notwithstanding the various benefits e.g. the CSOI wafers are capable of offering over traditional prior art solutions, some problems still remain therewith. For instance, during release etching in connection with creating e.g. a desired MEMS structure on a CSOI wafer, which may be achieved via application of e.g. inductively coupled plasma (ICP) etching or other suitable release etching method, etching may easily continue to the underlying material, such as a silicon surface of the wafer below, after penetrating the active layer. In worst case this additional, undesired removal of material may cause breakage of the associated wafer / device. Also, etching on the bottom of the cavity may cause an increase in the parasitic capacitance and uncontrolled change in the cavity volume.

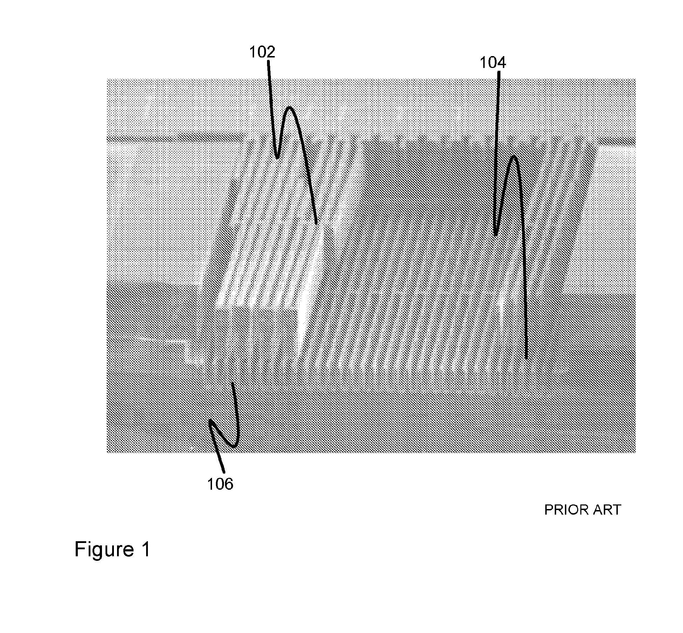

A related scenario is visualized in microscopic image of Figure 1, wherein anisotropic etching has been utilized to etch a MEMS structure 102 with cavities 104. However, undesired over-etching into the underlying wafer material has visibly occurred 106 at the bottom of the structure. Wider patterns are etched faster than narrower patterns, which causes etching to begin at the bottom of the cavity under wider structures sometimes long before the narrow structures are released. Even with uniform patterns the estimation of required time for penetrating the active layer is difficult as the etching speed may vary between the centre and the edge portions of the wafer. Therefore an extra period is often added to the estimated etching time to ensure the release of the structures in all areas, which results in the etching to take place on the bottom of the cavity, which is clearly visible in the figure. Etched patterns in the bottom of the cavity may decrease the robustness of the wafer as well as prevent / reduce possibilities for thinning down the handle silicon wafer under the cavity. Further, they may accumulate moisture and impurities.

Additionally, with conventional designs stiction may cause problems such as unwanted sticking of the MEMS device to the bottom of the formed cavity. Yet, e.g. an oxide layer deposited on a wafer may be under compression stress, which may cause deformation of both the wafer and related micromechanical structures.

### SUMMARY OF THE INVENTION

The objective is to at least alleviate one or more of the problems described hereinabove. The objective is achieved by different embodiments of a multi-layer substrate structure and a related method of manufacture in accordance with the present invention.

An aspect of the devised solution thus preferably incorporates fabrication of a bonded semiconductor substrate structure comprising one or more embedded cavity structures and at least one buried, thin-film deposited, advantageously ALD-deposited (Atomic Layer Deposition), layer such as a conformal ALD film assigned with a number of functional purposes. The deposited layer may form a continuous, solid layer or comprise different forms and e.g. holes therein. The obtained structure, which may be called as an ALD-CSOI structure in the case of ALD deposition, may be applied in MEMS manufacturing, for example. For instance, the first wafer may form at least a part of a thicker so-called support wafer layer, or "handle" wafer, of the obtained structure, whereas the second wafer may form at least a part of the thinner top surface layer, or "cap" wafer, or vice versa. The thickness of the deposited layer may fall within range from about 0.3 nm to about 1 µm, for example.

The deposited film comprising at least one material layer may act as an etch stop during further process stages incorporating releasing additional material from the substrate structure for obtaining a desired target structure such as a MEMS device and/or structure. A bonded wafer, or both of them, may be thinned by grinding, polishing, chemical-mechanical polishing (CMP), lapping, wet etching, and/or dry etching to the target thickness.

The obtained structure, such as the aforesaid ALD-CSOI structure, may be utilized in connection with and/or for manufacturing at least one element selected from the group consisting of: a MEMS element, a microfluidic element, a membrane, a beam (micro)structure, a beam array, a micro-mirror, an RF (Radio Frequency) MEMS, an optical MEMS, an actuator, a micro-bridge, and a sensor.

Accordingly, in one aspect of the present invention a multi-layer substrate structure comprises
- a first and second wafer, such as two silicon wafers, bonded together optionally with a number of intermediate layers, said first wafer comprising, on the side of the bond, a cavity, and
- a deposited, such as ALD-deposited, material layer arranged on either wafer so as to at least in places face the other wafer and cover at least portion of the cavity of the first wafer, such as bottom, wall, roof and/or edge thereof, and enable stopping etching, such as plasma etching, substantially before the underlying material is reached.

In one embodiment, a wafer may comprise or consist of at least one material selected from the group consisting of: silicon, glass, quartz, gallium arsenide, gallium nitride, silicon carbide, silicon germanium, indium phosphide, and silicon nitride. Thus e.g. different semiconductor materials may be utilized in the wafers. Indeed, a wafer may be provided with a plurality of materials and/or additional layers. For instance, a thin film layer, such as a (thermal) oxide layer, and/or a deposited layer may have been additionally provided thereon to form at least one intermediate layer between the first and second wafers. The thickness of this optional layer may fall within range from about 1 nm to about 90 µm, for example. In practice, the layer may be thus few nanometers or several tens of micrometers thick, for example. Such layer may be provided utilizing other method than ALD, even though ALD may also be applicable depending on each particular use scenario. One example is thermally grown silicon dioxide layer. The deposited layer may be provided on the oxide layer and/or directly on the original wafer material.

In another, either supplementary or alternative, embodiment the deposited etch-stop layer comprises at least one material selected from the group consisting of: alumina, titanium dioxide, and tantalum oxide. The deposited material(s) may be conductive and/or insulating. Accordingly, different suitable oxides and/or nitrides such as various metal oxides and/or nitrides may be case-specifically applied, for example.

In another aspect of the present invention, a method for manufacturing a multi-layer substrate structure comprises
- obtaining a first and second wafer, such as two silicon wafers, wherein at least one of the wafers may be optionally provided with a material layer such as an oxide layer thereon,
- forming a cavity on the bond side of the first wafer,
- depositing, optionally by ALD, a material layer on either wafer arranged so as to at least in places face the other wafer and cover at least portion of the cavity of the first wafer, such as bottom, wall, roof and/or edge thereof, and enable stopping etching, such as plasma etching, substantially before the underlying material is reached (308, 408), and
- bonding the wafers provided with at least the aforesaid deposited layer as an intermediate layer together to form the multi-layer semiconductor substrate structure preferably suitable for manufacturing e.g. a MEMS device.

In one embodiment, the method further comprises release-etching, i.e. removal of a predetermined sacrificial structure from the multi-layer substrate structure, to form the desired "released" microstructure, for example. The deposited layer prevents releasing from continuing into the underlying material that should remain intact. After releasing, further process steps such as coating and/or packaging may be executed depending on the embodiment in question.

In another, either supplementary or alternative, embodiment the oxide layer such as a silicon dioxide layer is first provided to the selected wafer(s) by a technique other than ALD such as thermal oxidation.

In a further, either supplementary or alternative, embodiment the aforesaid bonding process includes at least one bonding technique selected from the group consisting of: direct bonding, fusion bonding, plasma assisted low temperature bonding, anodic bonding, thermocompression bonding, eutectic bonding, adhesive bonding, and glass frit bonding.

Yet in a further, either supplementary or alternative, embodiment, one or both wafers are thinned. For example, the utilized thinning method may include a technique selected from the group consisting of: grinding, polishing, chemical-mechanical polishing (CMP), lapping, wet etching, layer transfer method, and dry etching. For example, the thickness of the thinned wafer may fall within range from about 1 nm to a plurality of µm.

Still in a further, either supplementary or alternative, embodiment the deposited layer is formed utilizing at least one deposition technique selected from the group consisting of: thermal ALD, plasma enhanced atomic layer deposition (PEALD), chemical vapour deposition (CVD), plasma enhanced chemical vapour deposition (PECVD), atmospheric pressure chemical vapour deposition (APCVD), low pressure chemical vapour deposition (LPCVD), metal organic chemical vapour deposition (MOCVD), and physical vapour deposition (PVD). The thermal ALD is also known as atomic layer epitaxy (ALE) or atomic layer chemical vapour deposition (ALCVD), for instance. Further, different variants of the aforesaid deposition techniques may be applied.

In a further, either supplementary or alternative, embodiment the cavity is fabricated applying at least one technique selected from the group consisting of: lithography optionally with applicable resist(s), dry etching, fluorine chemistry - based dry etching, wet etching, laser milling, ion milling, and MEMS technology configured to machine the substrate (wafer).

The previously presented considerations concerning the various embodiments of the substrate structure may be flexibly applied to the embodiments of the method mutatis mutandis and vice versa, as being appreciated by a skilled person.

The utility of the present invention follows from a plurality of issues depending on each particular embodiment. The deposited layer(s) may be conveniently utilized as etch stop layers, for instance, to stop e.g. plasma etching at desired locations such as the bottom of the cavity as well as, for example, under the device layer during releasing of target structures such as MEMS structure(s). For instance, even few nanometers of alumina can efficiently stop ICP etching. In connection with wide and narrow structures, i.e. patterns with different dimensions, to be etched substantially simultaneously, adjusting the etching time on the basis of the narrower structures, the etching of which generally takes longer with anisotropic plasma etching, may now take place without the risk of over-etching regarding the material underlying the wider patterns. Additionally, as the cavity structures are protected, there remain better possibilities to safely thin down the handle wafer in order to obtain smaller devices. Yet, the devices will be more robust (->higher yield) and cavity volumes more precisely definable in the light of the target design.

Further, e.g. ALD-deposited thin films can be deposited as smooth amorphous layers (e.g. alumina, Al2O3). After bonding the wafers, the smooth amorphous film can be crystallized by high temperature annealing, for example. During the crystallization the film roughness increases in areas where it is not supported from both sides by the wafers (on top/bottom of the cavity), as the bonded areas have been found to remain good enough during crystallization. Increasing the roughness of the film on bottom of the cavity may enable using it as anti-stiction layer for moving micromechanical structures thereon.

Yet, the deposited layer such as alumina layer may be configured to remain in tensile stress in contrast to e.g. the aforementioned thermally grown silicon dioxide, which is typically under compressive stress as deliberated hereinbefore. This enables the deposited material such as alumina to be utilized in minimizing the stresses in the SOI structures. By matching these stresses close to zero, the wafer curvature may be minimized as well as bending of released micromechanical structures can be avoided.

The use of ALD or other equally advantageous deposition method provides for obtaining conformal, uniform, and/or dense thin films with low amount of defects.

Various further details of the utility aspect of the various embodiments in accordance with the present invention are disclosed hereinafter.

The expression "a number of" refers herein to any positive integer starting from one (1), e.g. to one, two, or three.

The expression "a plurality of" refers herein to any positive integer starting from two (2), e.g. to two, three, or four.

The term "ALD" refers herein to ALD deposition in its wide meaning such that e.g. conventional thermal ALD and various variants, such as high(er) energy variants like PEALD, are covered therewith.

The term "wafer" refers herein to a slice or plate comprising desired material such as semiconductor material. The shape of the wafer may be round (disc), rectangular or of some other preferred design.

The term "cavity" refers herein to a feature machined into a target substrate such as a wafer. The cavity may be open-ended or closed. The cavity may define at least one groove, dent, blind hole, hollow, recess and/or some other, potentially more complex, shape in the substrate,

Different embodiments of the present invention are disclosed in the dependent claims.

### BRIEF DESCRIPTION OF THE RELATED DRAWINGS

Next the invention is described in more detail with reference to the appended drawings in which
Fig. 1 illustrates a prior art scenario wherein over-etching is clearly visible.
Fig. 2a illustrates selected aspects of contemporary CSOI manufacturing.
Fig. 2b illustrates an embodiment of the present invention in the context of CSOI manufacturing.
Fig. 3 illustrates a potential fabrication process for preparing multi-layer substrate structures (ALD-CSOI wafers).
Fig. 4 is a flow diagram disclosing an embodiment of a method in accordance with the present invention.

### DETAILED DESCRIPTION OF THE EMBODIMENTS

Figure 1 has already been reviewed in conjunction with the description of related art.

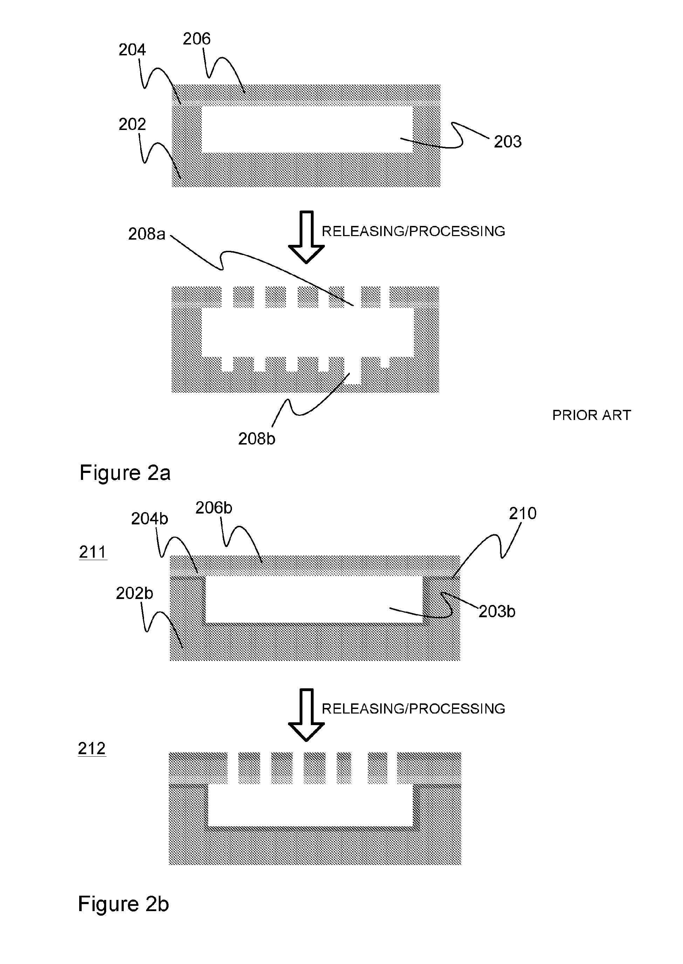

Figure 2a is a sketch of a similar prior art scenario in which a CSOI-type wafer is manufactured. A handle wafer 202 has been provided with a cavity 203 and a silicon dioxide layer 204. Then the cap wafer 206 has been bonded with the handle wafer 202 comprising the aforesaid intermediate oxide layer. Upon releasing the desired microstructures and etching the cap wafer 208a (see the lower part of the sketch), etching undesiredly continues into the cavity bottom 208b and partially thus ruins the obtained overall structure/device.

Figure 2b illustrates an embodiment of the present invention wherein, see first the top sketch at 211, a handle wafer 202b has been provided with at least one cavity 203b. The dimensions of the cavity may vary and it may contain a number of different shapes, forms, and patterns. The cavity 203b may include elongated, hexahedron or e.g. cubic shapes, or it may be a bowl-like, for example.

An intermediate layer, such as an oxide layer 204b like silicon dioxide layer, may have been provided to a bond side of either wafer 202b, 206b or both of them utilizing a suitable dry or wet oxidation technique, for example.

An ALD layer 210, which may be implemented as a continuous film or a more complex -shaped layer with a number of forms such as a hole therein, is formed on either wafer 202b, 206b, e.g. on the handle wafer 202b comprising the cavity 203b, to exhibit direct physical contact with the original wafer 202b, 206b material and/or with an intermediate layer such as the oxide layer 204b so that it may act as an etch-stop/etching mask layer for the desired structure(s) such as desired part(s) of the cavity structure(s) 203b.

Preferably the surface of the ALD layer is flawless in a sense that no pinholes are undesiredly present therein. Further preferably, it is made so flat and smooth that the desired bonding properties such as high bonding strength are possible to attain without need for chemical mechanical polishing (CMP), for example. The surface roughness of the bonding areas may advantageously be below a predetermined value defined on use case basis. The roughness may in some embodiments depend on the ALD growth temperature. It may thus be directly proportional to, inversely proportional to, or substantially independent of the temperature. With alumina, for example, inverse proportionality may be achievable. In addition to alumina, materials such as Ta2O5 (tantalum pentoxide), Ti02 (titanium dioxide), or a combination of alumina and/or the aforesaid materials may be utilized in addition to various other potential oxides and/or nitrides. Multiple layers may be disposed so as to form an aggregate structure of a plurality of superimposed layers.

At 212 it is shown how the deposited ALD layer may work in practice upon further processing of the constructed ALD-CSOI structure. During release processing of desired microstructures, parts of the wafer 206b material and oxide material 204b have been removed and the microstructures and their components such as the cavity bottom and walls has remained intact as desired.

Further, at least part of the ALD layer may be applied as an anti-stiction layer relative to micromechanical structure(s) that may move thereon. Many materials such as ALD-deposited alumina (Al2O3) may be grown as amorphous, but high temperature (heat) processing such as annealing may be utilized to crystallize them such that the surface roughness of the ALD-layer increases regarding e.g. areas not in contact with the wafer material or the intermediate material layer(s) such as oxide layer(s) provided on the original wafer material. Bonded areas and the bonds themselves advantageously remain good enough during crystallization with only reasonable roughening not affecting the bond strength and/or other properties to an adverse extent. For instance, temperature falling within range from about 600°C to about 900°C, e.g., from about 750°C to about 800°C, may be applied for crystallization. After crystallization, the AFM-determined (Atomic Force Microscope) RMS-roughness (Root Mean Square) of the ALD-deposited alumina may be greater than about 1.0 nm, for example. The alumina surface of this roughness does not attach to silicon or silicon oxide surfaces or other surfaces nearly as well as a smooth alumina layer.

Yet, as e.g. ALD-deposited alumina is under tensile stress the magnitude of which may fall within range from about 200 MPa to about 500 MPa, it may be utilized to minimize the overall tension in the light of an aggregate structure comprising the alumina layer and e.g. thermal silicon oxide layer under compression tension, and/or to minimize the thickness of the oxide layer. Control of the overall tension may be realized through the selection of layer thicknesses, for instance. Curvature changes of the wafers may be thereby reduced. Stress control may be particularly advantageous in connection with larger (silicon) wafers having a diameter of at least about 150 mm, for instance.

An ALD layer may contain further preferred properties, such as electrical and/or chemical properties, concerning the end structure.

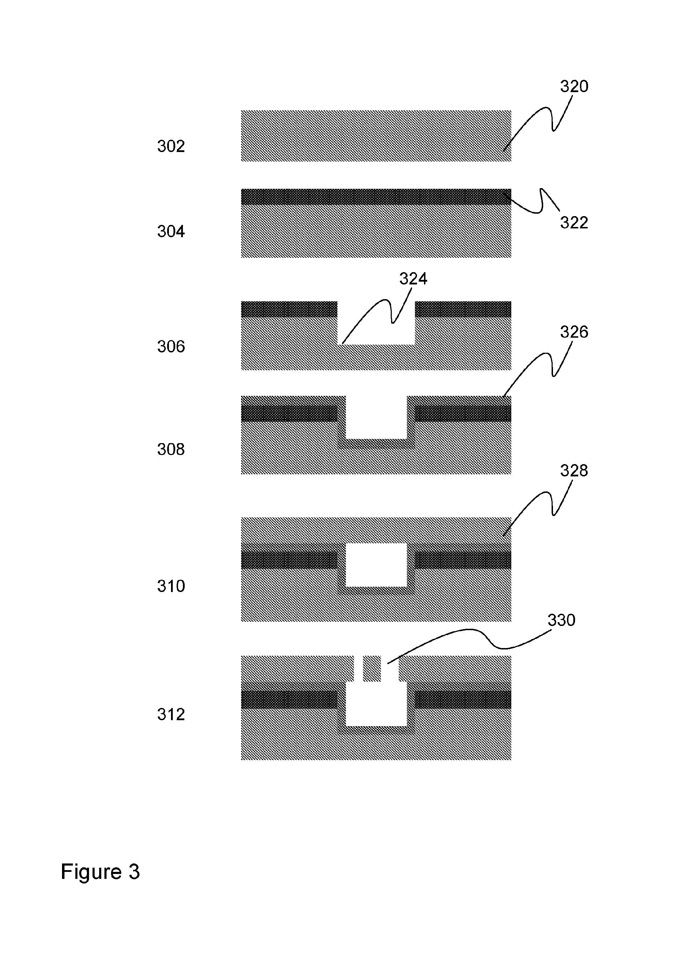

Figure 3 illustrates an embodiment of a potential fabrication process for preparing multi-layer substrate structures such as ALD-CSOI wafers.

In many use scenarios, the cavity/cavities may be formed first on selected one or more wafers, after which thin film layers are produced on the target surfaces of the wafers. However, application of a different sequence of method phases is also possible as is to be shown hereinafter.

At 302 a wafer 320 of predetermined material, such as silicon, and of dimensions/shape, such as round shape, is obtained. Necessary pre-processing and dimensioning may take place.

At 304 the wafer 320 is optionally provided with an oxide layer 322 such as a thermally grown silicon dioxide or other oxide layer. Oxidation may comprise dry and/or wet oxidation, for example. Applied temperatures may be included in a range from about 700°C to about 1200°C, for example. Yet, the oxide 322 may be provided using a feasible alternative technique such as LPCVD (Low Pressure Chemical Vapour Deposition) optionally at a lower temperature. In addition to or instead of oxides, other intermediate layer(s) may be established.

At 306 a number of cavities 324 are formed by a suitable technique such as milling and/or etching, for example.

At 308, a preferably conformal ALD layer 326 such as alumina layer is provided on the wafer 320. Alternatively or additionally, an ALD layer could also be provided on a predetermined side of the cap wafer as further mentioned below.

At 310, the established handle wafer structure is provided with a cap wafer 328 and necessary bonding and grinding actions are performed, resulting in an ALD-CSOI structure. The cap wafer 328 may optionally comprise material layer(s) such as oxide layer and/or ALD-layer thereon, e.g. on the side of the bond.

At 312 processing of the ALD-CSOI structure is continued towards the more application-specific target structure and/or device. Additional material 330 is removed by etching, for example, but the ALD-layer 326 protects the intended parts of the handle wafer 320.

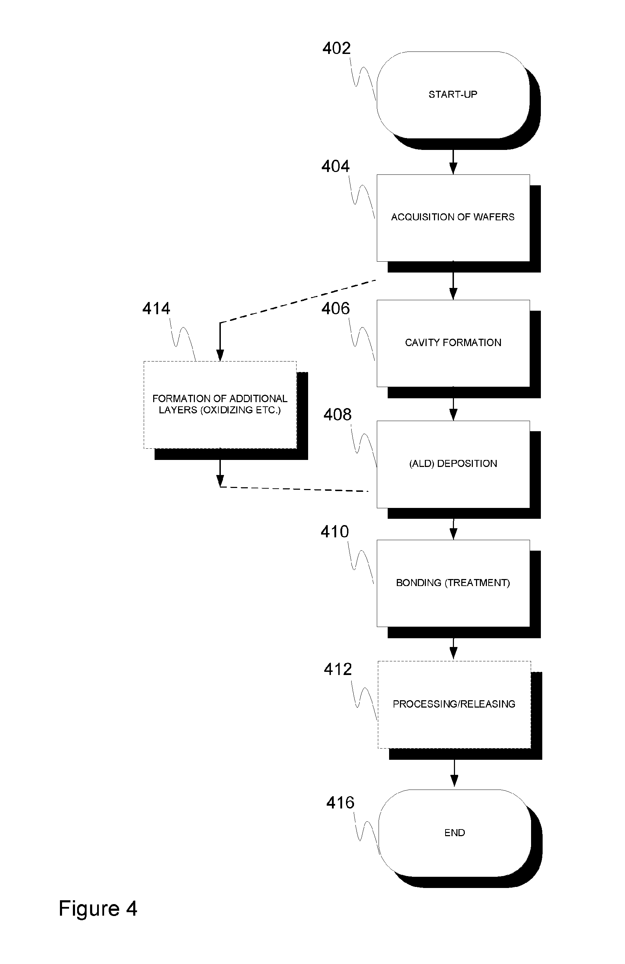

Figure 4 represents an embodiment of a method, by way of example only, in accordance with the present invention in a form of a flow diagram. Broken lines denote optional features.

At method start-up 402, necessary gear such as an ALD reactor, wafer bonding device, grinding device, and/or oxidation/diffusion system are obtained and configured in view of the application requirements, for instance.

At 404, a number of necessary wafers for creating the target multi-layer substrate structure comprising at least two wafer layers are obtained.

At 406, a number of cavity structures are fabricated to selected one or more wafers as described hereinearlier, for example.

At 408, selected one or more wafers are at least partially provided with advantageously conformal ALD film layer.

At optional item 414, additional, potentially intermediate, layers such as silicon-dioxide layers may be formed on selected one or more wafers at selected instant relative to the execution of other method phases (e.g. between cavity formation 406 and ALD-deposition 408).

At 410, bonding of the handle wafer to the corresponding cap wafer with a number of intermediate layers such as an oxide layer and the ALD layer is effectuated. Bonding may be executed under partial vacuum. For example, direct bonding may be applied. The wafer surfaces may be activated using suitable activation technique(s) to elevate adhesion and bond strength at low temperatures. The activation may be performed with plasma among other options. After bonding, heat treatment such as annealing may be performed. The related temperature may fall within range from about 100°C to about 1250°C, for instance.

At 412, the process may be continued by thinning one or both the wafers by grinding, chemical mechanical polishing (CMP), wet etching, and/or dry etching to a desired thickness. Releasing of the desired structure(s) may take place. For example, target MEMS may be produced using the fabricated multi-layer ALD-CSOI wafer as an intermediate product.

Method execution is ended at 416. The mutual ordering (e.g. in view of items 406 and 408) and overall presence of the method items, as already deliberated above, may be altered by a skilled person based on the requirements set by each particular use scenario.

Consequently, a skilled person may on the basis of this disclosure and general knowledge apply the provided teachings in order to implement the scope of the present invention as defined by the appended claims in each particular use case with necessary modifications, deletions, and additions. Instead or in addition to the ALD some other variation of CVD (Chemical Vapour Deposition) or PVD (Physical Vapour Deposition) could be utilized. For instance, PECVD (Plasma Enhanced Chemical Vapour Deposition), LPCVD (Low Pressure Chemical Vapour Deposition), APCVD (Atmospheric Pressure Chemical Vapour Deposition), or MOCVD (Metal Organic Chemical Vapour Deposition) may be applied. Further, different nanolaminate structures could be formed in connection with the application of an embodiment of the present invention.

## Claims

1. A multi-layer substrate structure (211, 212) comprising
- a first (202b, 320) and second (206b, 328) wafer, such as two silicon wafers, bonded together optionally with a number of intermediate layers (204b, 322), said first wafer comprising, on the side of the bond, a cavity (203b, 324), and
- a deposited, optionally ALD-deposited (Atomic Layer Deposition), material layer (210, 326) arranged on either wafer so as to at least in places face the other wafer and cover at least portion of the cavity of the first wafer, such as bottom, wall, roof and/or edge thereof, and enable stopping etching, such as plasma etching, substantially before the underlying material is reached.

2. The structure of claim 1, wherein a wafer may comprise at least one material selected from the group consisting of: silicon, glass, quartz, gallium arsenide, gallium nitride, silicon carbide, silicon germanium, indium phosphide, and silicon nitride.

3. The structure of any preceding claim, comprising an oxide layer, such as a thermally grown or deposited silicon dioxide layer, provided on either wafer as said intermediate layer between the first and second wafers.

4. The structure of any preceding claim, wherein said deposited material layer comprises at least one material selected from the group consisting of: alumina, titanium dioxide, silicon oxide, silicon nitride, and tantalum oxide.

5. The structure of any preceding claim, wherein said deposited material layer is arranged on the first wafer.

6. The structure of any preceding claim, wherein said first wafer is the handle or cap wafer and said second wafer is the cap or handle wafer, respectively.

7. A microstructure, such as a microdevice, comprising the multi-layer substrate structure of any preceding claim.

8. The microstructure of claim 7, comprising at least one element selected from the group consisting of: a MEMS (Micro-Electro-Mechanical System) element, a MEMS device, a microfluidic element, a membrane, a beam (micro)structure, a beam array, a micro-mirror, an RF (Radio Frequency) MEMS, an optical MEMS, an actuator, a micro-bridge, and a sensor.

9. A method for manufacturing a multi-layer substrate structure comprising
- obtaining a first and second wafer, such as two silicon wafers, wherein at least one of the wafers may be optionally provided with a material layer such as an oxide layer (302, 404),
- forming a cavity on the bond side of the first wafer (306, 406),
- depositing, optionally by ALD (Atomic Layer Deposition), a material layer, such as alumina layer, on either wafer arranged so as to at least in places face the other wafer and cover at least portion of the cavity of the first wafer, such as bottom, wall and/or edge thereof, and enable stopping etching, such as plasma etching, substantially before the underlying material is reached (308, 408), and
- bonding the wafers provided with at least the aforesaid deposited layer as an intermediate layer together to form the multi-layer semiconductor substrate structure (310, 312).

10. The method of claim 9, comprising release processing (312, 412) of a microstructure, wherein additional material is removed by etching.

11. The method of claim 9 or 10, wherein an oxide layer, such as silicon dioxide layer, is provided to either wafer (304, 414).

12. The method of any of claims 9-11, wherein said bonding comprises utilization of at least one bonding technique selected from the group consisting of: direct bonding, fusion bonding, plasma assisted low temperature bonding, anodic bonding, thermocompression bonding, eutectic bonding, adhesive bonding, and glass frit bonding.

13. The method of any of claims 9-12, wherein said first and/or second wafers are thinned.

14. The method of claim 13, wherein the utilized thinning method includes a technique selected from the group consisting of: grinding, polishing, chemical-mechanical polishing (CMP), lapping, wet etching, and dry etching.

15. The method of any of claims 9-14, wherein the deposited layer is formed utilizing at least one deposition technique selected from the group consisting of:
thermal atomic layer deposition (thermal ALD), plasma enhanced atomic layer deposition (PEALD), chemical vapour deposition (CVD), plasma enhanced chemical vapour deposition (PECVD), atmospheric pressure chemical vapour deposition (APCVD), low pressure chemical vapour deposition (LPCVD), metal organic chemical vapour deposition (MOCVD), and physical vapour deposition (PVD).

16. The method of any of claims 9-15, wherein the cavity is fabricated applying at least one technique selected from the group consisting of: lithography optionally with applicable resist(s), dry etching, fluorine chemistry -based dry etching, wet etching, laser milling, ion milling, and MEMS (Micro-Electro-Mechanical System) technology configured to machine the target wafer.

17. The method of any of claims 9-16, comprising crystallization of deposited material for providing an anti-stiction surface for microelements.

18. The method of claim 17, wherein the deposited material includes alumina, the AFM-RMS-roughness (Atomic Force Microscope, Root Mean Square) of which is greater than a predetermined value, such as about 1.0 nm, after crystallization.

19. The method of any of claims 9-18, wherein the deposited material, such as alumina, is under tensile stress the magnitude of which is controlled, by the applied deposition process, so as to minimize the overall tension in the light of an aggregate structure comprising the deposited layer and an oxide layer being under compression tension, and/or to minimize the thickness of the oxide layer.
